**Europäisches Patentamt**

**European Patent Office**

**Office européen des brevets**

(19)

(11) Veröffentlichungsnummer : **0 195 467**
**B1**

(12)

# EUROPÄISCHE PATENTSCHRIFT

(45) Veröffentlichungstag der Patentschrift :
03.01.90

(51) Int. Cl.$^5$ : **G 01 R 29/24, G 01 R 5/28**

(21) Anmeldenummer : 86200232.6

(22) Anmeldetag : 18.02.86

(54) Influenzsondenanordnung mit mehreren Influenzsonden.

(30) Priorität : 19.02.85 DE 3505615

(43) Veröffentlichungstag der Anmeldung :
24.09.86 Patentblatt 86/39

(45) Bekanntmachung des Hinweises auf die Patenterteilung : 03.01.90 Patentblatt 90/01

(84) Benannte Vertragsstaaten :
DE FR GB NL

(56) Entgegenhaltungen :
EP--A-- 0 030 056
FR--A-- 2 240 822
GB--A-- 2 043 271
US--A-- 4 134 137

(73) Patentinhaber : **Philips Patentverwaltung GmbH**
**Wendenstrasse 35 Postfach 10 51 49**
**D-2000 Hamburg 1 (DE)**
**DE**
**N.V. Philips' Gloeilampenfabrieken**
**Groenewoudseweg 1**
**NL-5621 BA Eindhoven (NL)**
**FR GB NL**

(72) Erfinder : **Conrads, Norbert**
**Stöck 9**
**B-4729 Hauset (BE)**
Erfinder : **Hillen, Walter, Dr.**
**Einsenweg 2**
**D-5100 Aachen (DE)**
Erfinder : **Quadflieg, Peter**
**Kirchrather Strasse 41**
**D-5100 Aachen (DE)**
Erfinder : **Schiebel, Ulrich, Dr.**
**Zehntweg 60**
**D-5100 Aachen (DE)**

(74) Vertreter : **Hartmann, Heinrich, Dipl.-Ing. et al**
**Philips Patentverwaltung GmbH Wendenstrasse 35**
**Postfach 10 51 49**
**D-2000 Hamburg 1 (DE)**

## Beschreibung

Die Erfindung betrifft eine Influenzsondenanordnung nach dem Oberbegriff des Anspruchs 1. Eine solche Influenzsondenanordnung ist aus der DE-A-29 48 660 bekannt. Da die bekannte Influenzsondenanordnung mit mehreren Influenzsonden versehen ist, kann damit die Ladungsverteilung auf einer aufgeladenen Oberfläche schneller ermittelt werden als mit Hilfe nur einer einzigen Influenzsonde. Die bei der bekannten Anordnung erforderlichen Leitungen zwischen den Sondenelektroden der einzelnen Influenzsonden und den zugeordneten hochohmigen Vorverstärkern können jedoch außer den eigentlichen Signalspannungen auch Störspannungen aufnehmen, und es ist sehr schwierig, diese Leitungen gegen solche Störspannungen abzuschirmen.

Weiterhin ist aus der FR-A-2 240 822 ein Detektor für einen Tintenstrahldrucker bekannt, der auf elektrisch geladene Tintentröpfchen anspricht. Dieser Detektor enthält in einer Ebene eine Sondenelektrode und eine die Sondenelektrode umgebende Abschirmelektrode, die über Leiterbahnen mit einem Verstärker verbunden sind.

Aufgabe der vorliegenden Erfindung ist es, eine Influenzsondenanordnung der eingangs genannten Art so auszubilden, daß die Signalleitungen von den Sondenelektroden zu den Vorverstärkern gegen Störspannungen besser abgeschirmt sind. Diese Aufgabe wird durch die im Anspruch 1 angegebenen Maßnahmen gelöst.

Bei der Erfindung verlaufen die Signalleiterbahnen also in der ersten Ebene, d. h. in einer Mittelebene, und die Abschirmleiterbahnen in dazu parallelen Ebenen auf den Seitenflächen der vorzugsweise plattenförmig ausgebildeten Substratanordnung, auf deren Stirnflächen sich die Sonden- bzw. die Abschirmelektroden befinden. Auf diese Weise ist die Signalleiterbahn gegen externe Störquellen, aber auch gegen ein Übersprechen aus benachbarten Signalleiterbahnen abgeschirmt.

Das Übersprechen von benachbarten Signalleiterbahnen kann noch weiter dadurch vermindert werden, daß in der ersten Ebene beiderseits jeweils einer Signalleiterbahn zwei weitere Abschirmleiterbahnen angeordnet sind, die mit der gleichen Abschirmelektrode verbunden sind. In weiterer Ausgestaltung der Erfindung ist vorgesehen, daß die Signalleiterbahnen mit dem Eingang und die zugehörigen Abschirmleiterbahnen mit dem Ausgang eines Spannungsfolgers verbunden sind. Dadurch ergibt sich beim Abtasten der elektrisch geladenen Oberfläche zwischen den Abschirm- und den Sondenelektroden ein homogenes elektrisches Feld ; zum anderen wird die Eingangskapazität des Spannungsfolgers wesentlich verringert.

Eine andere Weiterbildung der Erfindung sieht vor, daß die Abschirmelektrode auf der Stirnfläche von einer weiteren an Masse angeschlossenen Abschirmelektrode umgeben ist.

Dadurch werden äußere Störquellen noch weiter abgeschirmt. Ein erfindungsgemäßes Verfahren zur Herstellung einer derartigen Influenzsondenanordnung sieht vor, daß zur Herstellung der Abschirm- und Sondenelektroden auf die Stirnfläche einer mit Leiterbahnen in drei parallelen Ebenen versehenen Substratanordnung ein elektrisch leitender Belag aufgebracht wird und daß anschließend zur Bildung der elektrisch gegeneinander isolierten Sonden- und Abschirmelektroden ein Teil des Belages abgetragen wird. Vorzugsweise ist dabei vorgesehen, daß zur Herstellung der Substratanordnung zwei elektrisch isolierte Platten auf je einer Seite mit den Abschirmleiterbahnen versehen werden und daß wenigstens eine der beiden Platten auf der anderen Seite wenigstens mit den Signalleiterbahnen versehen wird und daß anschließend die Platten so zusammengefügt werden, daß die mit den Signalleiterbahnen versehene Seite in der Mitte liegt. Sowohl die Sonden- und die Abschirmelektroden als auch die damit verbundenen Signal- und Abschirmleiterbahnen können bei diesem Verfahren auf fotolithografischem Wege hergestellt werden, was eine wirtschaftliche Fertigung gewährleistet.

Die Erfindung wird nachstehend anhand der Zeichnung näher erläutert. Es zeigen :

Fig. 1 eine perspektivische Ansicht der Influenzsondenanordnung,

Fig. 2 einen Querschnitt durch den unteren Teil der Influenzsondenanordnung in einer zu den Leiterbahnebenen und der abzutastenden Oberfläche senkrechten Ebene,

Fig. 3 eine Aufsicht auf die Stirnfläche der Substratanordnung,

Fig. 4 die Anordnung der Leiterbahnen in der ersten Ebene,

Fig. 5 die Anordnung der Leiterbahnen in einer anderen Ebene,

Fig. 6 die Verbindung der Sonden- und der Abschirmelektroden mit einem Vorverstärker.

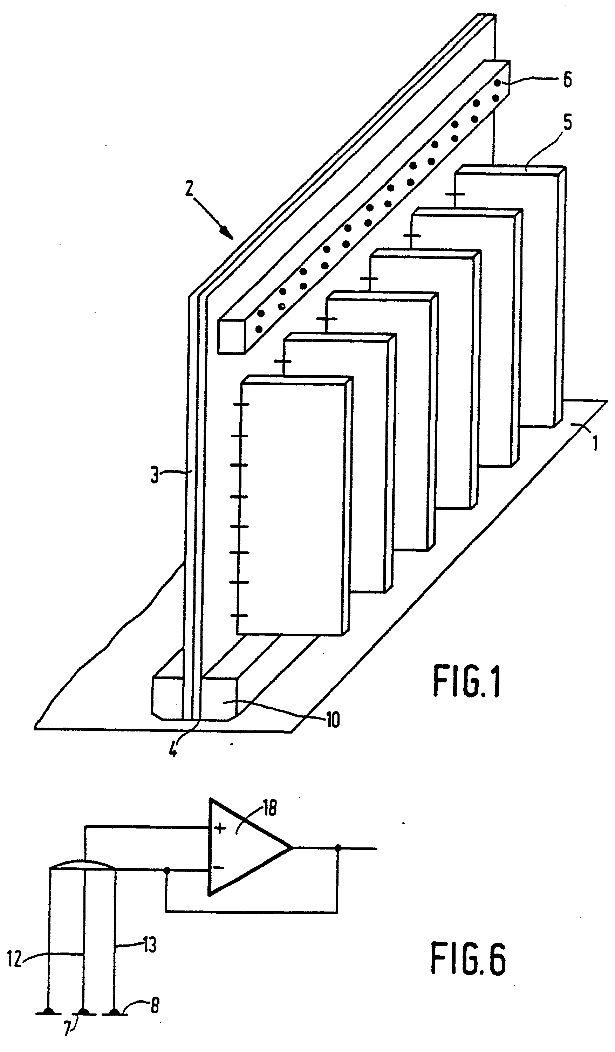

In Fig. 1 ist mit 1 eine ebene Oberfläche bezeichnet, die elektrisch aufgeladen ist. Die ebene Oberfläche kann zu einem Röntgenbildaufnehmer gehören, z. B. einer Selenplatte, auf der ein Ladungsmuster besteht, das der Intensitätsverteilung eines bei einer vorherigen Belichtung vorhandenen Röntgenstrahlenbildes entspricht. Dieses Ladungsmuster wird durch eine Influenzsondenanordnung 2 abgetastet, die gleichzeitig die Ladung an mehreren Punkten der Oberfläche 1 in elektrische Signale umsetzt. Die Geschwindigkeit, mit der die Ladungsverteilung auf der Oberfläche 1 abgetastet werden kann — wobei die Influenzsondenanordnung 2 und die Oberfläche 1 relativ zueinander verschoben werden — steigt dabei mit der Zahl der Punkte, deren Ladung gleichzeitig erfaßt wird.

Die Influenzsondenanordnung enthält dabei eine plattenförmige Substratanordnung 3, deren Stirnfläche parallel und in geringem Abstand, z. B. 100 μm, von der abzutastenden Oberfläche verläuft. Die Stirnfläche 4 ist mit Sondenelektroden versehen, deren Potential der Ladungsdichte unterhalb dieser Elektroden entspricht. Die Potentiale der einzelnen Elektroden werden von hochohmigen Vorverstärkern erfaßt, die sich in hybriden Verstärkermodulen 5 befinden und die über Leiterbahnen auf der Substratanordnung 3 mit den zugehörigen Sondenelektroden verbunden sind. Die Ausgangssignale der hybriden Verstärkermodulen sind an einer Steckerleiste 6 niederohmig abnehmbar und können dort durch geeignete elektronische Schaltungen weiterverarbeitet werden.

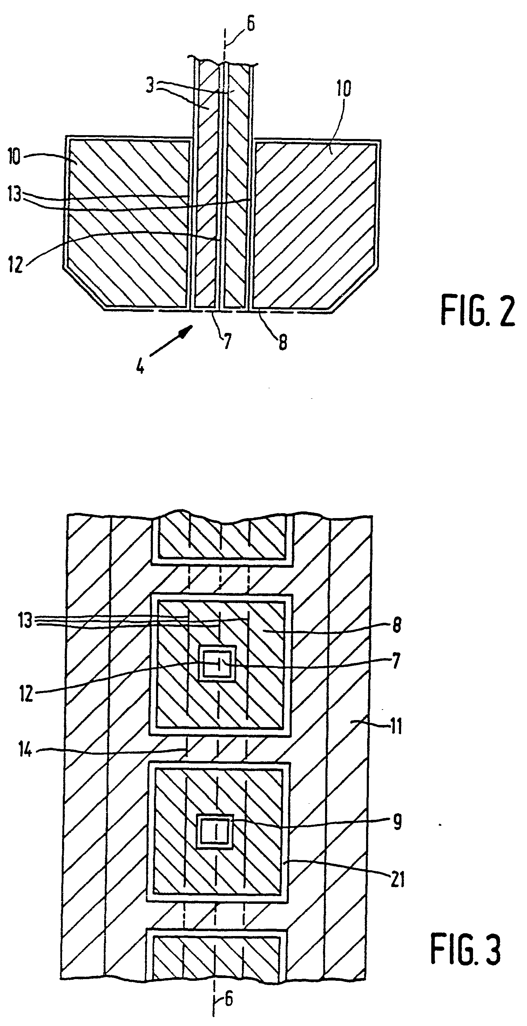

Wie insbesondere aus Fig. 2 erkennbar ist, die den unteren Teil der Influenzsondenanordnung in einem zur Oberfläche 1 und zur Substratanordnung 3 senkrechten Schnitt darstellt, besteht die Substratanordnung 3 aus zwei miteinander verbundenen ebenen Substratplatten. Die Substratplatten bestehen aus einem hochisolierenden mechanisch stabilen Werkstoff, z. B. $Al_2O_3$ und haben eine Dicke in der Größenordnung von 0,5 mm.

Wie Fig. 3 zeigt, sind auf der unteren Stirnfläche der Substratplatten 3 in regelmäßigen Abständen symmetrisch zu einer ersten Ebene 6, der Mittelebene zwischen den beiden Substratplatten 3, Sondenelektroden 7 angeordnet. Die Größe dieser Sondenelektroden bestimmen die Abmessungen des Bereichs, dessen Ladung jeweils erfaßt wird. Ein für die Auslesung von Röntgenbildern geeigneter Wert der Sondenelektrodenfläche liegt bei 150 × 150 µm. Jede Sondenelektrode 7 wird von einer Abschirmelektrode 8 umschlossen, die durch eine schmale Trennfuge 9 von der Sondenelektrode elektrisch isoliert ist. Die Abschirmelektroden 8 befinden sich zum Teil noch auf den Stirnflächen der Substratanordnung 3, zum Teil aber auch auf den in die Stirnflächen übergehenden ebenen Unterflächen von Verstärkungsleisten 10, die im unteren Bereich der Substratanordnung angebracht sind und ebenfalls aus isolierendem Material bestehen. Wie weiter unten noch näher erläutert wird, führen sie das gleiche Potential wie die von ihnen umschlossene Sondenelektrode, so daß sich bei der Abtastung der Oberfläche 1 zwischen dieser und der Sondenelektrode ein praktisch homogenes elektrisches Feld ausbildet.

Die Abschirmelektroden ihrerseits werden von einem elektrisch leitenden geerdeten Belag 11 umschlossen, der von den Abschirmelektroden durch eine Trennfuge 21 getrennt ist und der zumindest die Unterfläche der Verstärkungsleiste 10 bedeckt.

Die Sondenelektroden 7, Abschirmelektroden 8 und der Belag 11 sind mit Leiterbahnen verbunden, die sich auf den Seitenflächen der Substratanordnung 3 befinden. Wie insbesondere aus Fig. 3 hervorgeht, ist jede Sondenelektrode 7 an eine Signalleiterbahn 12 angeschlossen, die sich in der Mittelebene 6 der Substratanordnung, d. h. auf der Innenfläche einer der beiden Substratplatten 3 befindet. Jede Abschirmelektrode ist mit mehreren Leiterbahnen 13 verbunden. Diese befinden sich einerseits auf den Außenflächen der Substratanordnung 3 und andererseits auch auf der gleichen Innenfläche wie die Signalleiterbahnen. Auf diese Weise ist jede Signalleiterbahn vollständig von mehreren Abschirmleiterbahnen umschlossen (vgl. Fig. 3). Die Abschirmleiterbahnen auf den Außenflächen schirmen die Signalleiterbahnen insbesondere gegen von außen kommende Störungen ab, während die in der Mittelebene 6 befindlichen Abschirmleiterbahnen vor allem das Übersprechen zwischen benachbarten Signalleiterbahnen verhindern. Der Belag 11 ist mit Erdleitungen 14 verbunden, die auf den Außenflächen der Substratanordnung 3 geführt sind.

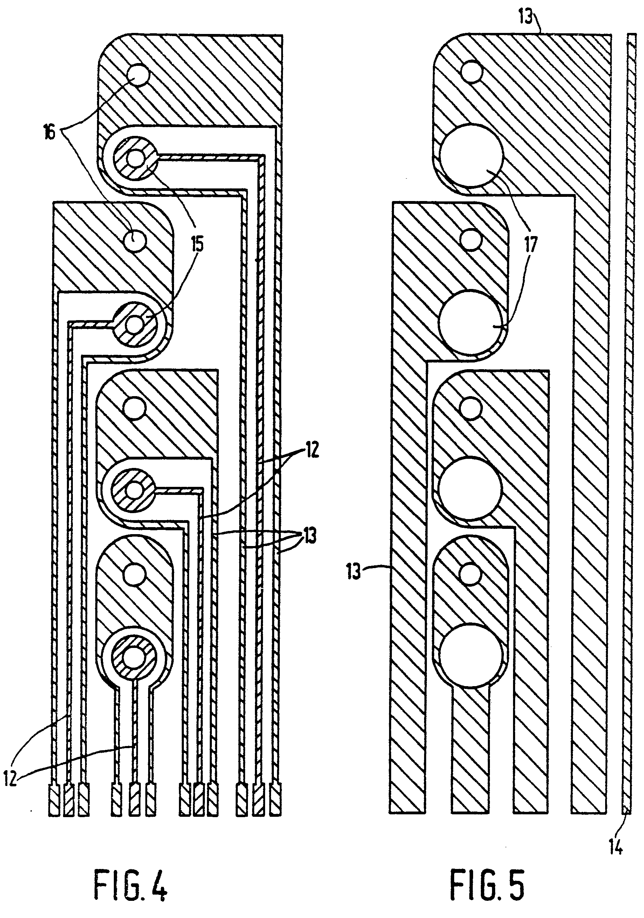

In Fig. 4 sind die Signal- und Abschirmleiterbahnen auf der Innenfläche der einen der beiden Substratplatten abgebildet, während in Fig. 5 die Abschirmleiterbahnen und eine Erdleiterbahn auf der Außenfläche der anderen Substratplatte dargestellt sind. Wie sich aus Fig. 4 ergibt, sind die Signalleiterbahnen, deren oberes Ende jeweils in eine Anschlußöse 15 einmündet, so geführt, daß die Anschlußösen von jeweils vier Signalleiterbahnen auf einer vertikalen Geraden liegen. Jede Signalleiterbahn 12 ist von je zwei Abschirmleiterbahnen 13 umgeben, die um die Anschlußöse der zugehörigen Leiterbahn herum miteinander verbunden sind, wobei die Abschirmleiterbahn in diesem Bereich verbreitert und mit einer Anschlußbohrung 16 versehen ist. Die Anordnung und die Form der zu den vier Signalleiterbahnen gehörigen Abschirmleiterbahnen auf der Außenfläche sind aus Fig. 5 ersichtlich. Die äußere Kontur jeder dieser Leiterbahnen entspricht der äußeren Kontur zweier zu einer Signalleiterbahn 12 gehörenden Abschirmleiterbahnen 13 mitsamt der verbreiterten Fläche. Im Bereich der Anschlußöse 15 weisen die Signalleiterbahnen jeweils eine kreisförmige Ausnehmung 17 auf, deren Durchmesser größer ist als der Durchmesser der Anschlußösen 15. Neben diesen Abschirmleiterbahnen befindet sich noch die Erdleiterbahn 14 auf der Außenfläche, wobei für die Influenzsonden auf der Substratanordnung 3 im allgemeinen eine Erdleiterbahn ausreicht, die zweckmäßigerweise die Verstärkermodule (Fig. 1) umschließt.

Die in Fig. 4 und 5 dargestellten zu jeweils vier Sonden- und vier Abschirmelektroden gehörigen Leiterbahnen setzen sich in horizontaler Richtung periodisch fort, so daß die Influenzsondenanordnung ein ganzzahliges Vielfaches von vier Influenzsonden tragen kann.

In Fig. 6 ist der Anschluß einer Sondenelektrode 7 und der sie umschließenden Abschirmelektrode 8 an einen der in einem Modul 5 enthaltenen Verstärker schematisch dargestellt. Der Verstärker wird durch einen Operationsverstärker 18 gebildet, dessen Ausgang mit dem invertierenden Eingang verbunden ist, so daß sich ein Verstärker mit niederohmigem Ausgang und der Spannungsverstärkung 1 (Spannungsfolger) ergibt. Die Abschirmelektrode 8 ist über die Leitung 13 mit dem invertierenden Eingang bzw. mit dem niederohmigem Ausgang des Verstärkers verbunden und die Sondenelektrode 7 ist über die Signalleitung 12 mit dem nichtinvertierenden Eingang des Verstärkers verbunden. Wegen dessen Spannungsfolgereigenschaft nimmt die Abschirmelektrode 8 dasselbe Potential an, wie die Signalelektrode 7, und zwar selbst dann, wenn die Ladungsdichte im Bereich der Abschirmelektrode sich wesentlich von derjenigen im Bereich der Signalelektrode unterscheidet.

Zur Herstellung der Influenzsondenanordnung werden zunächst zwei Aluminium-Oxid-Keramik-Platten in der erforderlichen Größe hergestellt. Auf die Platten werden dann die Leiterbahnen aufgebracht, vorzugsweise in fotolithografischer Technik. Dabei wird die eine Leiterplatte beidseitig und die andere Platte einseitig — gegebenenfalls aber auch zweiseitig mit einer etwa 6 μ dicken Goldschicht versehen — beispielsweise durch Aufdampfen. Anschließend werden die Abschirm- und Erdleiterbahnen auf beiden Keramikplatten gemäß Fig. 5 bzw. spiegelbildlich dazu auf fotolithografischem Wege ausgeätzt. Ebenso werden auf der noch unbehandelten Goldschicht der einen — und gegebenenfalls auch der anderen — Keramikplatte die Signal- und Abschirmleiterbahnen gemäß Fig. 4 ausgeätzt. Danach werden die beiden Platten durch einen geeigneten Kleber zusammengeklebt, wonach die Verstärkungsleisten 10 — vorzugsweise ebenfalls durch Kleben — mit den Keramikplatten verbunden werden. Die Stirnfläche der durch das Zusammenkleben der Keramikplatten entstandenen Substratanordnung und die damit zusammenfallende Fläche der Verstärkungsleisten werden anschließend plangeschliffen und poliert, bis die Leiterbahnen (unter dem Mikroskop) sichtbar werden. Auf die so behandelte Fläche wird eine Goldschicht aufgedampft, die dann in elektrischem Kontakt mit den Signal-, Abschirm- und Erdleiterbahnen steht. In diese Schicht werden dann ebenfalls auf fotolithografischem Wege die Trennfugen 9, 21 eingeätzt (Fig. 3), so daß ein geerdeter Belag 11 und davon und voneinander elektrisch isolierte Sonden- und Abschirmelektroden 7, 8 entstehen, die jeweils mit den zugehörigen Leiterbahnen kontaktiert sind.

Danach werden die Bohrungen für die Anschlußösen 15 bzw. die Ausnehmungen 16 angebracht, so daß jeweils acht Bohrungen auf einer vertikalen Geraden liegen. In diese Bohrungen werden Kontaktstifte eingesetzt und mit der umgebenden Leiterbahn durch einen geeigneten elektrisch leitenden Kleber verbunden. Die in die Anschlußösen 15 eingesetzten Stifte ragen dabei aus den Öffnungen 17 heraus, ohne mit diesen in elektrischen Kontakt zu treten. Mit je acht auf einer auf einer vertikalen Geraden liegenden Kontaktstiften wird, wie aus Fig. 1 ersichtlich, ein Hybridverstärker-Modul verbunden, das jeweils vier Vorverstärker enthält. Die Hybridverstärker-Module 5 können direkt mit den Kontaktstiften verbunden sein. Es ist jedoch zweckmäßiger, die Hybridverstärker-Module 5 mitsamt der Steckerleiste 6 auf einer Schaltungsplatine anzubringen, die mit Leitungsbahnen zur Verbindung der Verstärkerausgänge mit der Steckerleiste 6 und mit Buchsen zur Aufnahme der Kontaktstifte versehen ist.

Wenn die Sondenelektroden wesentlich dichter liegen bzw. wenn die Hybridverstärker-Module 5 zu große Abmessungen haben, können diese Module auch auf beiden Seiten der Substratanordnung angebracht werden.

Bei der bisher beschriebenen Ausführungsform besteht die Substratanordnung aus zwei Keramikplatten, wobei die Leiterbahnen in drei Ebenen zu deren Stirnfläche geführt sind. Der Abstand zweier benachbarter Sondenelektroden ist dabei stets etwas größer als die Abmessungen einer Abschirmelektrode, so daß pro Längeneinheit nur eine relativ geringe Anzahl von Sondenelektroden vorhanden sein kann. Diese Zahl läßt sich vergrößern, indem man mehr als zwei Substratplatten benutzt, auf deren Innen- und Außenflächen die Leiterbahnen angebracht sind, und wenn man die Sondenelektroden nicht mehr auf einer Geraden, sondern gegeneinander versetzt anordnet.

## Patentansprüche

1. Influenzsondenanordnung (2) zur Erfassung der Ladungsverteilung auf einer elektrisch aufgeladenen Oberfläche (1), mit mehreren Influenzsonden, die jeweils eine Sondenelektrode (7) und eine die Sondenelektrode (7) umgebende Abschirmelektrode (8) aufweisen, die auf der der Oberfläche (1) zugewandten Stirnfläche (4) einer gemeinsamen Substratanordnung (3) angebracht sind, wobei die Substratanordnung (3) Signalleiterbahnen (12) aufweist, die elektrisch leitend mit der jeweiligen Sondenelektrode (7) verbunden sind, dadurch gekennzeichnet, daß die Substratanordnung (3) in einer ersten, zur Stirnfläche (4) wenigstens annähernd senkrechten Ebene (6) die Signalleiterbahnen (12) aufweist und in zwei beiderseits der ersten Ebene (6) befindlichen und dazu parallelen Ebenen jeweils die Signalleiterbahnen (12) abschirmende Abschirmleiterbahnen (13) trägt, die elektrisch leitend mit der jeweiligen Abschirmelektrode (8) verbunden sind.

2. Influenzsondenanordnung nach Anspruch 1, dadurch gekennzeichnet, daß in der ersten Ebene (6) beiderseits jeweils einer Signalleiterbahn (12) zwei weitere Abschirmleiterbahnen (13) angeordnet sind, die mit der gleichen Abschirmelektrode (8) verbunden sind.

3. Influenzsondenanordnung nach einem der vorhergehenden Ansprüche, dadurch gekennzeichnet, daß die Signalleiterbahnen (12) mit dem Eingang und die zugehörigen Abschirmleiterbahnen (13) mit dem Ausgang eines Spannungsfolgers (18) verbunden sind.

4. Influenzsondenanordnung nach einem der vorhergehenden Ansprüche, dadurch gekennzeichnet, daß die Abschirmelektrode (8) auf der Stirnfläche (4) von einer weiteren an Masse angeschlossenen Abschirmelektrode (11) umgeben ist.

5. Influenzsondenanordnung nach Anspruch 4, dadurch gekennzeichnet, daß beiderseits der Substratanordnung (3) Zusatzkörper (10) angeordnet sind, die eine in die Stirnfläche (4) der Substratanordnung (3) übergehende Fläche aufweisen, die wenigstens einen Teil der weiteren Abschirmelektrode (11) trägt.

6. Influenzsondenanordnung nach Anspruch 4, dadurch gekennzeichnet, daß die weitere Abschirmelektrode (11) über wenigstens eine Leiterbahn (14) mit Masse verbunden ist, die in wenigstens einer der beiderseits der ersten Ebene (6) befindlichen Ebenen geführt ist.

7. Verfahren zur Herstellung einer Influenzsondenanordnung nach einem der vorhergehenden Ansprüche, dadurch gekennzeichnet, daß zur Herstellung der Abschirm- und Sondenelektroden (8, 7) auf die Stirnfläche (4) einer mit Leiterbahnen in drei parallelen Ebenen versehenen Substratanordnung (3) ein elektrisch leitender Belag aufgebracht wird und daß anschließend zur Bildung der elektrisch gegeneinander isolierten Sonden- und Abschirmelektroden (7, 8) ein Teil (9, 21) des Belages abgetragen wird.

8. Verfahren nach Anspruch 7, dadurch gekennzeichnet, daß zur Herstellung der Substratanordnung zwei elektrisch isolierte Platten (3) auf je einer Seite mit den Abschirmleiterbahnen (13) versehen werden und daß wenigstens eine der beiden Platten auf der anderen Seite wenigstens mit den Signalleiterbahnen (12) versehen wird und daß anschließend die Platten (3) so zusammengefügt werden, daß die mit den Signalleiterbahnen (12) versehene Seite in der Mitte liegt.

## Claims

1. An induction probe arrangement (2) for determining the charge distribution on an electrically charged surface (1), comprising several induction probes, provided with a probe electrode (7) and a shielding electrode (8) which surrounds the probe electrode (7), which electrodes are mounted on an end face (4) of a common substrate arrangement (3) which faces the surface (1), the substrate arrangement (3) comprising signal-conducting paths (12) which are electrically conductively connected to the respective probe electrode (7), characterized in that the substrate arrangement (3) is provided with the signal-conducting paths (12) in a first plane (6) which is at least approximately perpendicular to the end face (4), and carries, in two planes extending on each side of the first plane (6) and parallel thereto, shielding paths (13) which are electrically conductively connected to the respective shielding electrode (8).

2. An induction probe arrangement as claimed in Claim 1, characterized in that in the first plane (6) on each side of a signal conducting path (12) there are provided two further shielding paths (13) which are connected to the same shielding electrode (8).

3. An induction probe arrangement as claimed in any one of the preceding Claims, characterized in that the signal-conducting paths (12) are connected to the input and the associated shielding paths (13) are connected to the output of a voltage follower (18).

4. An induction probe arrangement as claimed in any one of the preceding Claims, characterized in that the shielding electrode (8) on the end face (4) is surrounded by a further shielding electrode (11) which is connected to ground.

5. An induction probe arrangement as claimed in Claims 4, characterized in that on both sides of the substrate arrangement (3) there are provided additional members (10) which have a surface running into the end face of the substrate arrangement (3) and carrying at least part of the further shielding electrode (11).

6. An induction probe arrangement as claimed in claim 4, characterized in that the further shielding electrode (11) is connected to the ground via at least one conducting path (14) which is disposed in at least one of the planes situated on both sides of the first plane (6).

7. A method of manufacturing an induction probe arrangement as claimed in any one of the preceding Claims, characterized in that the shielding and probe electrodes (8, 7) are constructed by depositing an electrically conductive layer on the end face (4) of a substrate arrangement (3) provided with conducting paths in three planes, after which a part (9, 21) of the layer is removed in order to form the probe and shielding electrodes (7, 8) which are electrically insulated from one another.

8. A method as claimed in Claim 7, characterized in that for the manufacture of the substrate arrangement two electrically insulated plates (3) are provided with the shielding paths (13) on each time one side, at lest one of the plates being provided with at least the signal-conducting paths (12) on the other side, the plates (3) being subsequently joined so that the side provided with the signal-conducting paths (12) is situated in the middle.

## Revendications

1. Dispositif de sondes à induction (2) pour déterminer la distribution des charges sur une surface chargée électriquement (1), avec plusieurs sondes à induction comportant une électrode de sondage (7) et une électrode de blindage (8) entourant l'électrode de sondage (7), qui sont disposées sur la face d'about (4) tournée vers la surface (1) d'un dispositif de support commun (3), le dispositif de support (3) présentant des pistes conductrices de signaux (12) qui sont connectées électriquement à l'électrode de sondage (7) correspondante, caractérisé en ce que le dispositif de support (3) présente les pistes conductrices de signaux (12) dans un premier plan (6) au moins approximativement perpendiculaire à la face d'about (4) et dans deux plans situés de part et d'autre du premier plan (6) et parallèles à celui-ci, les pistes conductrices de blindage (13) qui protègent les pistes conductrices de signaux (12) et qui sont connectées électriquement à l'électrode de blindage (8) correspondante.

2. Dispositif de sondes à induction suivant la revendication 1, caractérisé en ce que dans le premier plan (6), de part et d'autre de chaque piste conductrice de signaux (12), sont prévues deux autres pistes conductrices de blindage (13) qui sont connectées à la même électrode de blindage (8).

3. Dispositif de sondes à induction suivant l'une des revendications précédentes, caractérisé en ce que les pistes conductrices de signaux (12) sont connectées à l'entrée et les pistes conductrices de blindage (13) correspondantes, à la sortie d'un amplificateur d'isolation (18).

4. Dispositif de sondes à induction suivant l'une quelconque des revendications précédentes, caractérisé en ce que l'électrode de blindage (8) sur la face d'about (4) est entourée par une autre électrode de blindage (11) connectée à la masse.

5. Dispositif de sondes à induction suivant la revendication 4, caractérisé en ce que, de part et d'autre du dispositif de support (3), sont disposés des corps supplémentaires (10) présentant une face qui se fond dans la face d'about (4) du dispositif de support (3) et qui porte au moins une partie de l'autre électrode de blindage (11).

6. Dispositif de sondes à induction suivant la revendication 4, caractérisé en ce que l'autre électrode de blindage (11) est connectée à la masse par au moins une piste conductrice (14) qui est prévue dans au moins l'un des plans s'étendant de part et d'autre du premier plan (6).

7. Procédé de fabrication d'un dispositif de sondes à induction suivant l'une quelconque des revendications précédentes, caractérisé en ce que, pour la fabrication des électrodes de blindage et de sondage (8, 7), un revêtement électriquement conducteur est appliqué sur la face d'about (4) d'un dispositif de support (3) pourvu de pistes conductrices dans trois plans parallèles et qu'ensuite, pour la formation des électrodes de sondage et de blindage (7, 8) isolées électriquement les unes des autres, une partie (9, 21) du revêtement est éliminée.

8. Procédé suivant la revendication 7, caractérisé en ce que, pour la fabrication du dispositif de support, deux plaques électriquement isolées (3) sont chacune pourvues de pistes conductrices de blindage (13) sur une face et qu'au moins l'une des deux plaques est pourvue au moins des pistes conductrices de signaux (12) sur l'autre face, et que les plaques (3) sont ensuite assemblées d'une manière telle que le côté pourvu des pistes conductrices de signaux (12) se trouve au milieu.

FIG.1

FIG.6

FIG. 2

FIG. 3

2

FIG. 4

FIG. 5